# EUROPEAN PATENT APPLICATION

(11) **EP 2 738 829 A1**
(43) Date of publication of application: **04.06.2014**
(21) Application number: 12818369.6
(22) Date of filing: 25.07.2012
(51) Int. Cl.: H01L 51/30, C08G 61/12, H01L 51/05, H01L 51/42

(54) **ORGANIC SEMICONDUCTOR MATERIAL**

(30) Priority: 25.07.2011 JP 2011162625
(71) Applicant: National University of Corporation Hiroshima University, Higashihiroshima-shi Hiroshima 739-8511 (JP)
(72) Inventor: OSAKA, Itaru, Higashihiroshima-shi Hiroshima 739-8527 (JP); TAKIMIYA, Kazuo, Higashihiroshima-shi Hiroshima 739-8527 (JP)
(74) Representative: v. Bezold & Partner Patentanwälte - PartG mbB
(86) International application number: PCT/JP2012/068781
(87) International publication number: WO 2013/015298

(57) **Abstract**

Provided is an organic semiconductor material with good crystallinity and an excellent carrier mobility. The organic semiconductor material comprises a backbone represented by formula 1. In formula 1, R¹ is hydrogen, an alkyl group, an alkylcarbonyl group, an alkoxy group, or an alkoxycarbonyl group, m is an integer of 1 or more, Ar is a monocyclic or condensed polycyclic heteroaromatic ring optionally comprising a substituent, and when a plurality of heteroaromatic rings are linked, the same or different heteroaromatic rings are optionally linked.

## Description

### Technical Field

The present invention relates to an organic semiconductor material.

### Background Art

In recent years, organic thin film transistors, organic thin film solar cells, and the like utilizing organic semiconductor materials have been energetically researched and developed. In the case of using organic semiconductor materials, thin-film-shaped organic semiconductor layers can be produced by a simple method with a wet process such as a printing method or a spin coating method. Therefore, there are advantages that such organic semiconductor materials have low production costs in comparison with inorganic semiconductor materials and are able to provide semiconductor elements that are thin and have excellent flexibility. Therefore, various organic semiconductor materials have been energetically researched and developed.

For example, Non Patent Literatures 1 to 4 disclose organic semiconductor materials comprising benzothiadiazole. Further, Non Patent Literature 5 discloses an organic semiconductor material comprising benzothiadiazole or naphthobisthiadiazole.

### Citation List

### Non Patent Literature

Non Patent Literature 1: Ming Zhang, Hoi Nok Tsao, Wojciech Pisula, Changduk Yang, Ashok K. Mishra, and Klaus Mullen; Field-Effect Transistors Based on a Benzothiadiazole-Cyclopentadithiophene Copolymer; Journal of The American Chemical Society 2007, 129, 3472-3473.
Non Patent Literature 2: Kok-Haw Ong, Siew-Lay Lim, Huei-Shuan Tan, Hoi-Ka Wong, JunLi, Zhun Ma, Lionel C. H. Moh, Suo-Hon Lim, John C. de Mello, and Zhi-Kuan Chen; A Versatile Low Bandgap Polymer for Air-Stable, High-Mobility Field-Effect Transistors and Efficient Polymer Dolar Cells; ADVANCED MATERIALS, 2011, 23, 1409-1413.
Non Patent Literature 3: David Muhlbacher, Markus Scharber, Mauro Morana, Zhengguo Zhu, David Waller, Russel Gaudiana, and Christoph Brabec; High Photovoltaic Performance of a Low-Bandgap Polymer; Advanced Materials, 2006, 18, 2884-2889.
Non Patent Literature 4: Jianhui Hou, Hsiang-Yu Chen, Shaoqing Zhang, Gang Li, and Yang Yang; Synthesis, Characterization, and Photovoltaic Properties of a Low Band Gap Polymer Based on Silole-Containing Polythiophenes and 2,1,3-Benzothiadiazole; Journal of the American Chemical Society, 2008, 130, 16144-16145.
Non Patent Literature 5: Ming Wang, Xiaowen Hu, Peng Liu, Wei Li, Xiong Gong, Fei Huang, and Yong Cao; A Donor-Acceptor Conjugated Polymer Based on Naphtho[1,2-c:5,6-c]thiadiazole for High Performance Polymer Solar Cells; Journal of The American Chemical Society,01 June 2011, 133, 9638-9641

### Summary of Invention

### Technical Problem

The organic semiconductor materials of Non Patent Literatures 1 and 2 have problems that the organic semiconductor materials do not have very high carrier mobilities in organic thin film transistors and are on unpractical levels.

The organic semiconductor materials of Non Patent Literatures 2 to 4 have problems that the organic semiconductor materials do not have very high photoelectric conversion efficiencies and are difficult to apply to organic thin film solar cells.

Further, in the organic semiconductor material of Non Patent Literature 5, a thiophene ring is bound to a polymer main chain in a perpendicular direction, an alkyl group that is a soluble group is substituted through the thiophene ring, and therefore the structural degrees of freedom of the side chains are high. Therefore, when the film of the organic semiconductor material is produced to form an organic semiconductor layer, the crystallinity of the material thin film is not high. When the crystallinity of the thin film is low, a carrier mobility is not high, and it is therefore difficult to use the organic semiconductor material as a material for a thin film transistor.

The present invention was accomplished with respect to the above matters, and an objective of the present invention is to provide an organic semiconductor material with good crystallinity and an excellent carrier mobility.

### Solution to Problem

An organic semiconductor material according to a first aspect of the present invention comprises a backbone represented by formula 1: 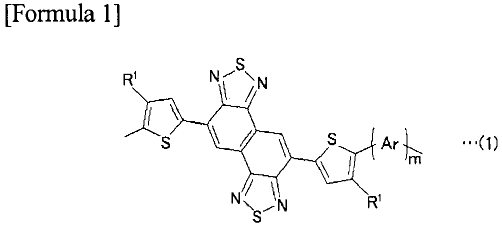 (in formula 1, R¹ is hydrogen, an alkyl group, an alkylcarbonyl group, an alkoxy group, and an alkoxycarbonyl group, m is an integer of 1 or more, Ar is a monocyclic or condensed polycyclic heteroaromatic ring optionally comprising a substituent, and when a plurality of heteroaromatic rings are linked, the same or different heteroaromatic rings are optionally linked).

The organic semiconductor material is preferably a polymer compound comprising the backbone as a repeating unit.

The monocyclic heteroaromatic ring is preferably a thiophene ring or a selenophene ring.

The condensed polycyclic heteroaromatic ring is preferably represented by any of formula 11 to formula 16: 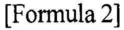 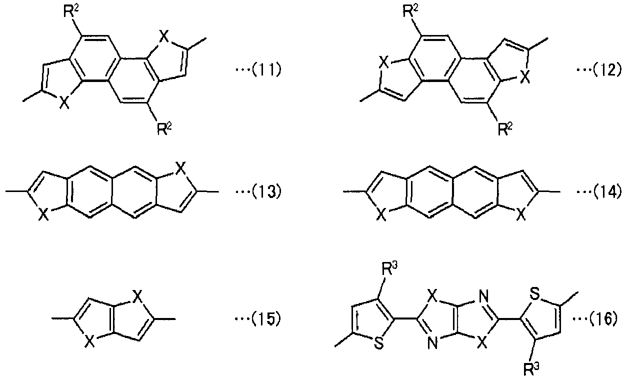 (in formula 11 to formula 16, X represents an oxygen, sulfur, or selenium atom; in formula 11 and formula 12, R² represents hydrogen, an alkyl group, an alkylcarbonyl group, an alkoxy group, an alkoxycarbonyl group, or an aromatic ring optionally comprising a substituent; and in formula 16, R³ represents an alkyl group, an alkylcarbonyl group, an alkoxy group, or an alkoxycarbonyl group).

An organic semiconductor material according to a second aspect of the present invention is represented by any of formula 21 to formula 24: 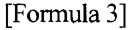 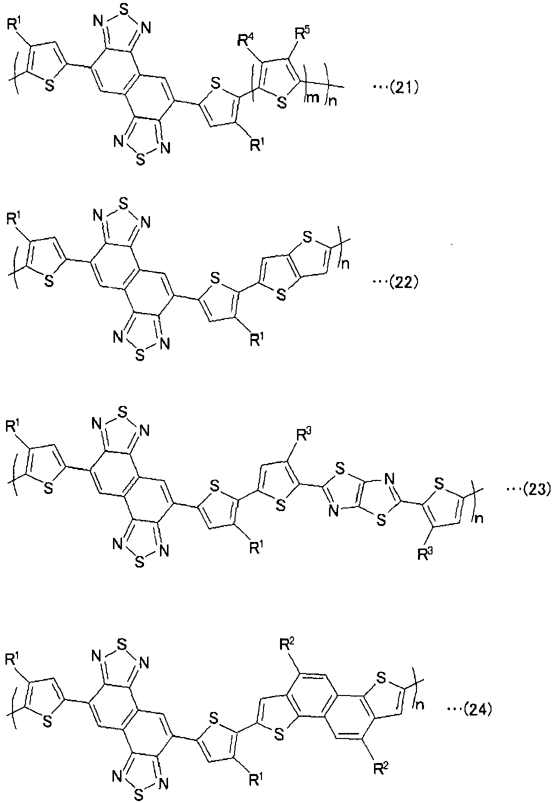 (in formula 21 to formula 24, R¹ represents hydrogen, an alkyl group, an alkylcarbonyl group, an alkoxy group, or an alkoxycarbonyl group, and n represents a positive real number; in formula 21, R⁴ and R⁵ represent hydrogen, an alkyl group, an alkylcarbonyl group, an alkoxy group, or an alkoxycarbonyl group, and m represents an integer of 1 or more; in formula 23, R³ represents an alkyl group, an alkylcarbonyl group, an alkoxy group, or an alkoxycarbonyl group; and in formula 24, R² represents hydrogen, an alkyl group, an alkylcarbonyl group, an alkoxy group, an alkoxycarbonyl group, or an aromatic ring optionally comprising a substituent).

### Advantageous Effects of Invention

The organic semiconductor material according to the present invention comprises a backbone in which a heteroaromatic ring is bound to naphthobisthiadiazole. In addition, as the substituent of the heteroaromatic ring, an alkyl group, an alkylcarbonyl group, an alkoxy group, or an alkoxycarbonyl group is directly bound to the heteroaromatic ring. The organic semiconductor material according to the present invention exhibits good crystallinity and has an excellent carrier mobility since the substituent is directly bound to a conjugated main chain.

### Brief Description of Drawings

FIG. 1 is a graph that indicates the current density-voltage characteristics of a solar cell element produced using a polymer compound P1;
FIG. 2 is a graph that indicates the current density-voltage characteristics of a solar cell element produced using a polymer compound P3;
FIG. 3 is a graph that indicates the current density-voltage characteristics of a solar cell element produced using a polymer compound P4;
FIG. 4 is a graph that indicates the current density-voltage characteristics of a solar cell element produced using a polymer compound P5;
Each of FIGS. 5A and 5B is a graph that indicates the transfer and output characteristics of a transistor element produced using a polymer compound P2;
Each of FIGS. 6A and 6B is a graph that indicates the transfer and output characteristics of a transistor element produced using the polymer compound P3;
Each of FIGS. 7A and 7B is a graph that indicates the transfer and output characteristics of a transistor element produced using the polymer compound P4;

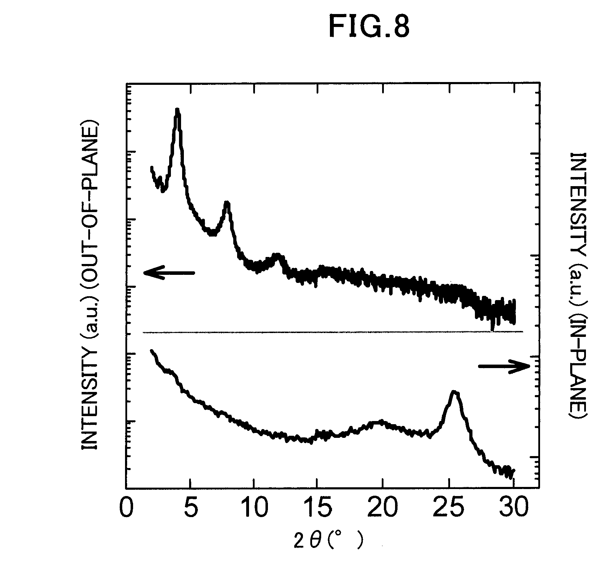

FIG. 8 is the X-ray diffraction pattern of the organic semiconductor layer of the polymer compound P3; and

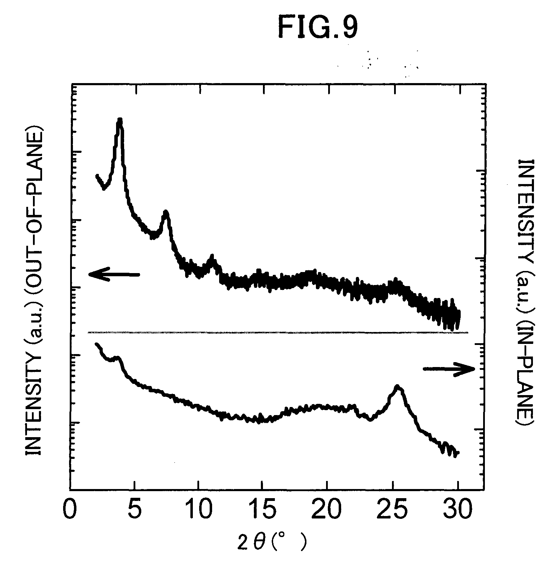

FIG. 9 is the X-ray diffraction pattern of the organic semiconductor layer of the polymer compound P4.

### Description of Embodiments

### (Embodiment 1)

An organic semiconductor material according to the present embodiment comprises a backbone represented by formula 1.

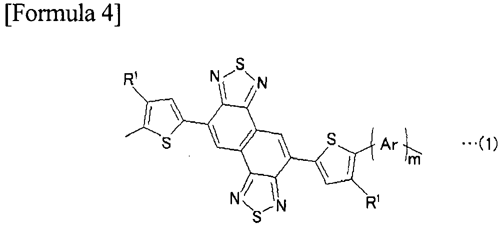

In the above formula 1, R¹ is hydrogen, an alkyl group, an alkylcarbonyl group, an alkoxy group, or an alkoxycarbonyl group. Further, m represents an integer of 1 or more. Further, Ar is a monocyclic or condensed polycyclic heteroaromatic ring optionally comprising a substituent. When a plurality of heteroaromatic rings are linked, the same or different heteroaromatic rings are optionally linked.

The organic semiconductor material according to the present embodiment comprises a naphthobisthiadiazole backbone, and naphthobisthiadiazole is an electron-deficient (electron-accepting) heteroaromatic condensed ring. When the units other than the naphthobisthiadiazole backbone are electron-donating (donating) units, in the organic semiconductor material according to the present embodiment, polarization occurs in the molecule, the improvement of an intermolecular interaction and the longer wavelength of absorbed light can be expected, and the organic semiconductor material can be utilized as a p-type organic semiconductor material for an organic transistor, an organic thin film solar cell, or the like. In contrast, when the units other than the naphthobisthiadiazole backbone are electron-accepting (accepting) units, the organic semiconductor material according to the present embodiment can be utilized as an n-type organic semiconductor material.

The above organic semiconductor material may be a low-molecular-weight compound and is preferably a polymer compound comprising formula 1 as a repeating unit.

When R¹ is hydrogen in formula 1, the heteroaromatic ring is provided with an alkyl group, an alkylcarbonyl group, an alkoxy group, or an alkoxycarbonyl group as a substituent. In such a case, the substituent is directly linked to a conjugated main chain.

Since the above substituent is directly linked to the conjugated main chain of the organic semiconductor material, the organic semiconductor material according to the present embodiment has a structure with a low structural degree of freedom and high orientation. In other words, the crystallinity of an organic semiconductor layer obtained by producing a film using the organic semiconductor material according to the present embodiment becomes good. Further, as described in later examples, a π-π stacking distance is around 3.5 Å, which is very short, in the organic semiconductor layer obtained by producing the film of the organic semiconductor material according to the present embodiment. The organic semiconductor material according to the present embodiment has such characteristics that hopping of holes or electrons easily occurs and a carrier mobility is excellent because of having good crystallinity and a short π-π stacking distance as described above. In addition, the number of substituents in formula 1 (in one unit) is preferably one or more and four or less. The reason thereof is that the too large number of substituents results in deterioration of packing in the case of obtaining an organic semiconductor device due to the effect of the configuration of the substituents.

Examples of the above-mentioned monocyclic heteroaromatic ring include a thiophene ring or a selenophene ring.

Further, the condensed polycyclic heteroaromatic ring is preferably a backbone represented by formula 11 to formula 16 below. In formula 11 to formula 16, X represents an oxygen, sulfur, or selenium atom. In formula 11 and formula 12, R² represents hydrogen, an alkyl group, an alkylcarbonyl group, an alkoxy group, an alkoxycarbonyl group, or an aromatic ring optionally comprising a substituent. In formula 16, R³ represents an alkyl group, an alkylcarbonyl group, an alkoxy group, or an alkoxycarbonyl group.

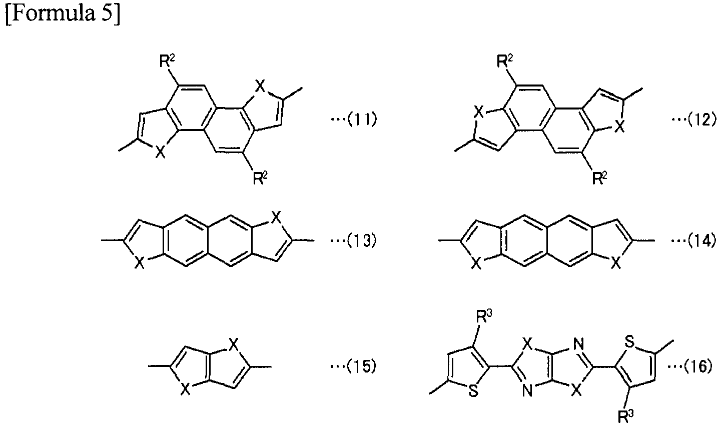

Specific examples of the organic semiconductor material according to the present embodiment include structures represented by formula 21 to formula 24.

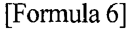

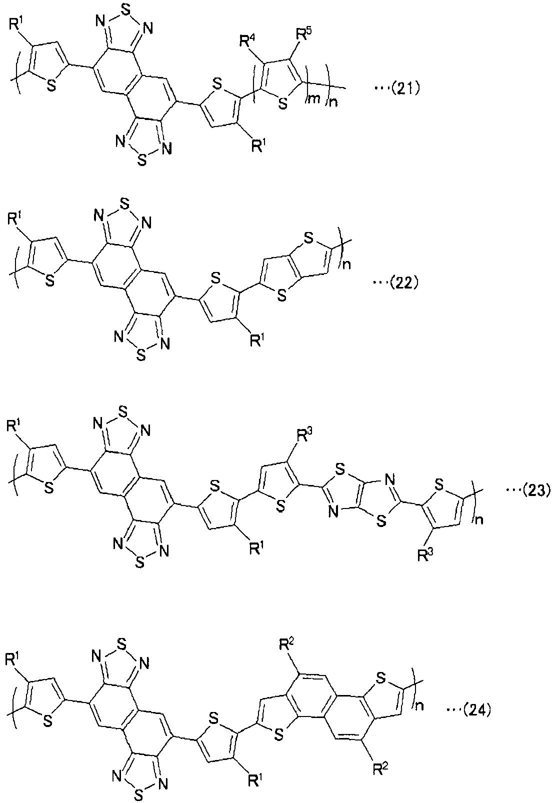

In formula 21 to formula 24, R¹ represents hydrogen, an alkyl group, an alkylcarbonyl group, an alkoxy group, or an alkoxycarbonyl group, and n represents a positive real number. In formula 21, m represents an integer of 1 or more, and R⁴ and R⁵ represent hydrogen, an alkyl group, an alkylcarbonyl group, an alkoxy group, or an alkoxycarbonyl group. In formula 23, R³ represents an alkyl group, an alkylcarbonyl group, an alkoxy group, or an alkoxycarbonyl group. In formula 24, R² represents hydrogen, an alkyl group, an alkylcarbonyl group, an alkoxy group, an alkoxycarbonyl group, or an aromatic ring optionally comprising a substituent.

The organic semiconductor material according to the present embodiment is excellent in solubility in an organic solvent because of comprising an alkyl group, an alkylcarbonyl group, an alkoxy group, or an alkoxycarbonyl group as a substituent as mentioned above. Particularly in the case of forming an organic semiconductor layer by a wet process when a semiconductor element for an organic transistor, an organic thin film solar cell, or the like is produced using the organic semiconductor material that is a polymer compound, the organic semiconductor material is very effective.

In the wet process, first, the organic semiconductor material is dissolved in an organic solvent. In addition, the solution is used to form an organic semiconductor layer on a substrate or the like by a spin coating method or the like. Since the organic semiconductor material according to the present embodiment exhibits excellent solubility in an organic solvent, the organic semiconductor layer with a uniform thickness can be easily formed. Further, since the organic semiconductor material is in the form of being generally homogeneously dispersed in the solution, the homogeneous organic semiconductor layer is formed. Furthermore, in the organic semiconductor material in which a five-membered ring such as a thiophene ring is bound to naphthobisthiadiazole, steric hindrance is reduced in comparison with a benzene ring or the like, and molecular arrangement with higher orientation is therefore formed. Accordingly, the organic thin film solar cell and the organic thin film transistor that are obtained using the organic semiconductor material according to the present embodiment exhibit good photoelectric conversion efficiency and charge mobility.

### Examples

Various polymer compounds (organic semiconductor materials) were synthesized, solar cell elements and transistor elements were produced, and the characteristics thereof were evaluated.

### (Synthesis of Polymer Compound P1)

Each of 4,8-dibromonaphtho[1,2-c:5,6-c']bis[1,2,5]thiadiazole (hereinafter, compound 1) (40.2 mg, 0.1 mmol), 4,4'-bis(2-hexyldecyl)-2,6-bis(trimethyltin)cyclopenta[2,1-b:3,4-b']-dithiophene (95.3 mg, 0.1 mmol), tetrakis(triphenylphosphine)-palladium (0) (2.3 mg, 2 mmol), and toluene (5 ml) was added to a reaction solution. A tube was filled with argon and then sealed, and the resultant was allowed to react at 180°C for 40 minutes using a µ-wave reactor. The compound 1 was prepared according to "Sufur Nitride in Organic Chemistry. Part 19. Selective Formation of Benzo- and Benzobis[1,2,5]thiadiazole Skeleton in the Reaction of Tetranitride with Naphthalenols and Related Compounds; S Mataka, K Takahashi, Y Ikezaki, T Hatta, A Torii, and M Tashiro; Bull. Chem. Soc. Jpn., 64, 68-73, 1991 ".

The resultant was cooled to room temperature, and the reaction solution was then poured into a mixture solution of methanol (100 ml) and hydrochloric acid (2 ml) and was subjected to reprecipitation.

The reaction mixture was Soxhlet-cleaned with methanol and hexane, then subjected to Soxhlet extraction with chloroform, and subjected to reprecipitation with methanol to obtain a polymer compound P1 (45 mg, 25%) as a dark green solid. The number average molecular weight and weight average molecular weight of the polymer compound P1 were 12,100 and 18,000, respectively.

The formula of the reaction described above is illustrated below.

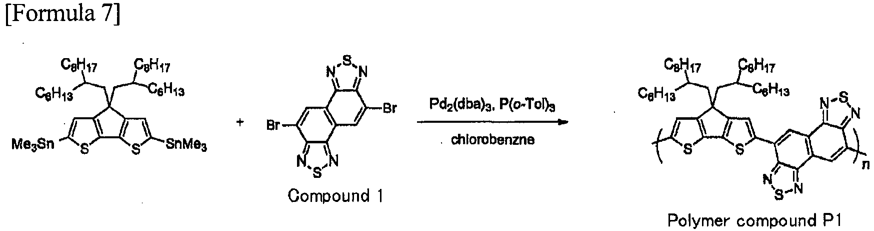

### (Synthesis of Polymer Compound P2)

Each of the compound 1 (20.1 mg, 0.05 mmol), 4,4'-bis(hexadecyl)-2,6-bis(trimethyltin)cyclopenta[2,1-b:3,4-b']-dithiophene (47.6 mg, 0.05 mmol), tetrakis(triphenylphosphine)-palladium (0) (1.16 mg, 1 mmol), and toluene (5 ml) was added to a reaction solution. A tube was filled with argon and then sealed, and the resultant was allowed to react at 180°C for 40 minutes using a µ-wave reactor. The resultant was cooled to room temperature, and the reaction solution was then poured into a mixture solution of methanol (100 ml) and hydrochloric acid (2 ml) and was subjected to reprecipitation. The reaction mixture was Soxhlet-cleaned with methanol and hexane, then subjected to Soxhlet extraction with chloroform, and subjected to reprecipitation with methanol to obtain a polymer compound (P2) (37 mg, 85%) as a dark green solid. The number average molecular weight and weight average molecular weight of the polymer compound P2 were 5,800 and 7,600, respectively.

The formula of the reaction described above is illustrated below.

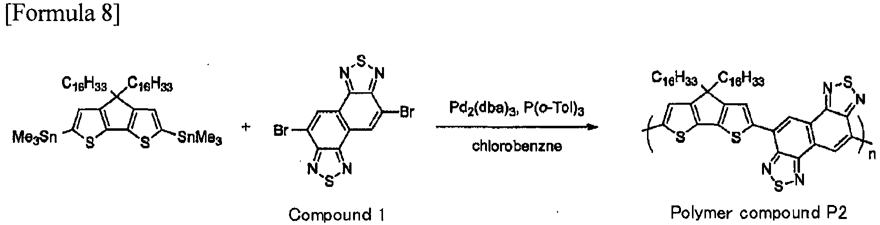

### (Synthesis of Polymer Compound P3)

A polymer compound P3 was stepwise synthesized as follows.

### (Synthesis of 4,8-bis(4-(2-decyltetradecyl)thiophen-2-yl)-naphtho[1,2-c:5,6-c']bis[1,2,5]thiadiazole (hereinafter, compound 2))

Under nitrogen atmosphere, 25 ml of toluene was put into a three-necked flask, which was degased for 30 minutes. Then, the compound 1 (201 mg, 0.5 mmol), 4-(2-decyltetradecyl)-2-trimethylstannylthiophene (584 mg, 1 mmol), and tetrakis(triphenylphosphine)-palladium (0) (11.5 mg, 10 mol) were added and subjected to reflux for 14 hours.

The resultant was cooled to room temperature and then poured into an aqueous saturated potassium fluoride solution, methylene chloride was added, and the resultant was subjected to extraction.

The resultant was cleaned with each of water and a saturated salt solution, magnesium sulfate was then added, and the resultant was dried. Then, filtration and concentration were performed, and a compound 2 (454 mg, 84%) was obtained as a red solid by isolation by column chromatography with a mixed solvent hexane:methylene chloride =2:1 as a mobile phase.

### (Synthesis of 4,8-bis (4-(2-decyltetradecyl)-5-bromothiophen-2-yl)-naphtho[1,2-c:5,6-c']bis[1,2,5]thiadiazole (hereinafter, compound 3))

Under nitrogen atmosphere, the compound 2 (270 mg, 0.25 mmol) and THF (15 ml) were added into a three-necked flask and cooled to 0°C.

N-Bromosuccinimide (89 mg, 0.5 mmol) was added thereinto, and the resultant was returned to room temperature and stirred for 4 hours.

Then, the reaction solution was poured into an aqueous calcium carbonate solution, methylene chloride was added, and the resultant was subjected to extraction.

The resultant was cleaned with each of water and a saturated salt solution, magnesium sulfate was then added, and the resultant was dried.

Then, filtration and concentration were performed, and a compound 3 (242 mg, 78%) was obtained as a red solid by isolation by column chromatography with a mixed solvent hexane:methylene chloride =2:1 as a mobile phase.

The formula of the reaction described above is illustrated below.

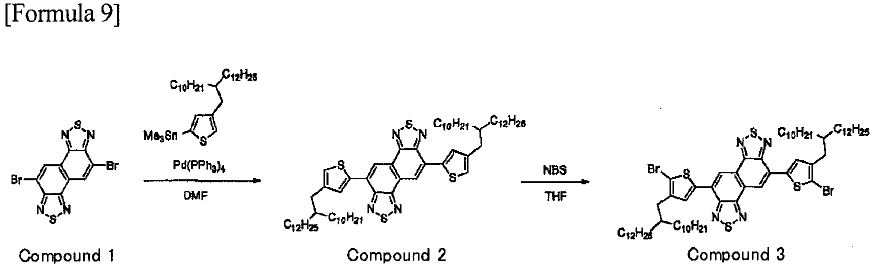

### (Synthesis of Polymer Compound P3)

Each of the compound 3 (124.0 mg, 0.1 mmol), 2,7-bis(trimethylstannyl)naphtho[1,2-b:5,6-b']dithiophene (56.6 mg, 0.1 mmol), tetrakis(triphenylphosphine)-palladium (0) (2.3 mg, 2 mmol), and toluene (5 ml) was added into a reaction vessel.

A tube was filled with argon and then sealed, and the resultant was allowed to react at 180°C for 40 minutes using a µ-wave reactor.

The resultant was cooled to room temperature, and the reaction solution was then poured into a mixture solution of methanol (100 ml) and hydrochloric acid (2 ml) and was subjected to reprecipitation.

The reaction mixture was Soxhlet-cleaned with methanol, hexane, and chloroform, then subjected to Soxhlet extraction with chlorobenzene, and subjected to reprecipitation with methanol to obtain a polymer compound P3 (98 mg, 74%) as a dark violet solid.

The number average molecular weight and weight average molecular weight of the polymer compound P3 were 30,000 and 300,000, respectively.

The formula of the reaction described above is illustrated below.

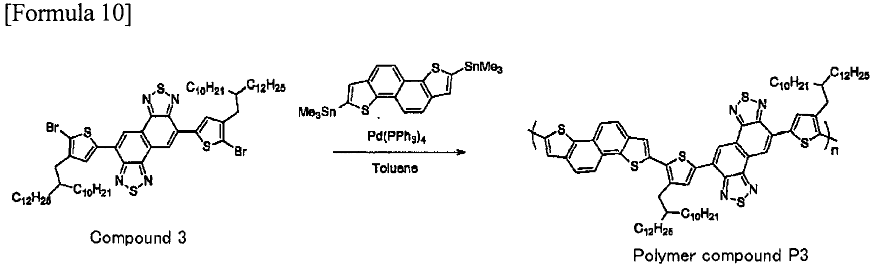

### (Synthesis of Polymer Compound P4)

Each of the compound 3 (124.0 mg, 0.1 mmol), 2-2'-bis(trimethyltin)bithiophene (49.2 mg, 0.1 mmol), tetrakis(triphenylphosphine)-palladium (0) (2.3 mg, 2 mmol), and toluene (5 ml) was added into a reaction vessel.

A tube was filled with argon and then sealed, and the resultant was allowed to react at 180°C for 40 minutes using a µ-wave reactor.

The resultant was cooled to room temperature, and the reaction solution was then poured into a mixture solution of methanol (100 ml) and hydrochloric acid (2 ml) and was subjected to reprecipitation.

The reaction mixture was Soxhlet-cleaned with methanol, hexane, and chloroform, then subjected to Soxhlet extraction with chlorobenzene, and subjected to reprecipitation with methanol to obtain P5 (117 mg, 94%) as a dark violet solid.

The number average molecular weight and weight average molecular weight of the polymer compound P4 were 52,600 and 126,000, respectively.

The formula of the reaction described above is illustrated below.

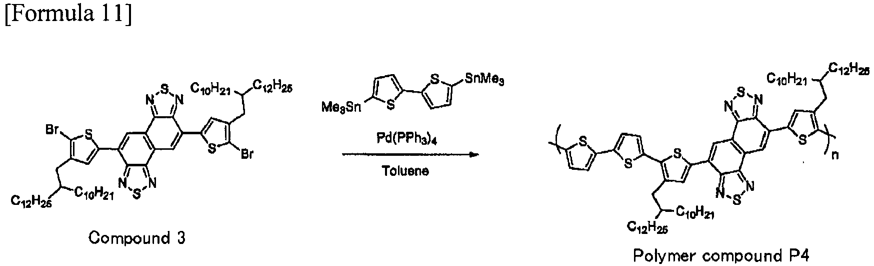

Further, a polymer compound P5 was synthesized as a comparative example.

Under nitrogen atmosphere, distilled chlorobenzene (10 ml) was put into a three-necked flask, which was degased for 30 minutes. Then, each of 4,7-dibromo -2,1,3 benzothiadiazole (29.4 mg, 0.1 mmol), 4,4'-bis(hexadecyl)-2,6-bis(trimethyltin)cyclopenta[2,1-b:3,4-b']-dithiophene (95.2 mg, 0.1 mmol), and tris(dibenzylideneacetone)dipalladium (2.1 mg, 2 mmol) was added and subjected to reflux for 2 days. The resultant was cooled to room temperature, and the reaction solution was then poured into a mixture solution of methanol (100 ml) and hydrochloric acid (2 ml) and was subjected to reprecipitation.

The reaction mixture was Soxhlet-cleaned with methanol and hexane, then subjected to Soxhlet extraction with chloroform, and subjected to reprecipitation with methanol to obtain a polymer compound P5 (45.7 mg, 85%) as a dark green solid. The number average molecular weight and weight average molecular weight of the polymer compound P5 were 11,000 and 15,600, respectively.

The formula of the reaction described above is illustrated below.

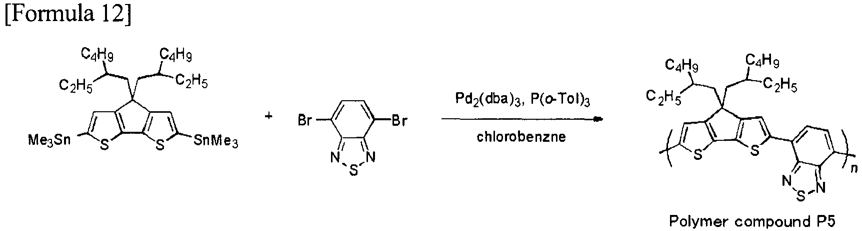

Subsequently, solar cell elements were produced using the synthesized polymer compounds P1, P3, P4, and P5, and photoelectric conversion efficiency was evaluated.

### (Evaluation of Solar Cell Element Using Polymer Compound P1)

A photoactive layer was produced (film thickness of about 100 nm) on a glass substrate with an ITO film by spin coating using an ortho-dichlorobenzene solution containing the polymer compound P1 and C₆₁ PCBM (phenyl C61-butyric acid methyl ester) as a fullerene derivative (weight ratio of polymer compound P1/PCBM = 1/1). Then, by a vacuum metallizer, lithium fluoride was vapor-deposited to have a thickness of 5 nm, and Al was then vapor-deposited to have a thickness of 100 nm to obtain an organic thin film solar cell. The obtained organic thin film solar cell has a shape that is a circle having a diameter of 2 mm, and has an area of 0.0314cm².

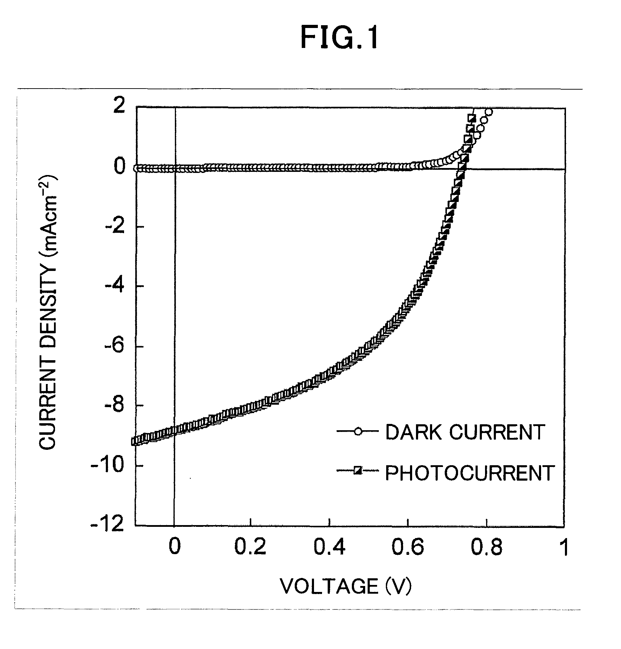

The obtained organic thin film solar cell was irradiated with constant light using a solar simulator (AM 1.5 G filter, irradiance of 100 mW/cm²), and generated current and voltage were measured. The graph of the current density-voltage characteristics is indicated in FIG. 1.

From obtained FIG. 1, a short-circuit current density (Jsc), an open voltage (Voc), and a fill factor (FF) were determined to be Jsc (short-circuit current density) = 8.82 mA/cm², Voc (open voltage) = 0.74 V, and FF (fill factor) = 0.45. A photoelectric conversion efficiency (η) was calculated to be 3.0% from Expression η = (Jsc x Voc x FF)/100.

### (Evaluation of Solar Cell Element Using Polymer Compound P3)

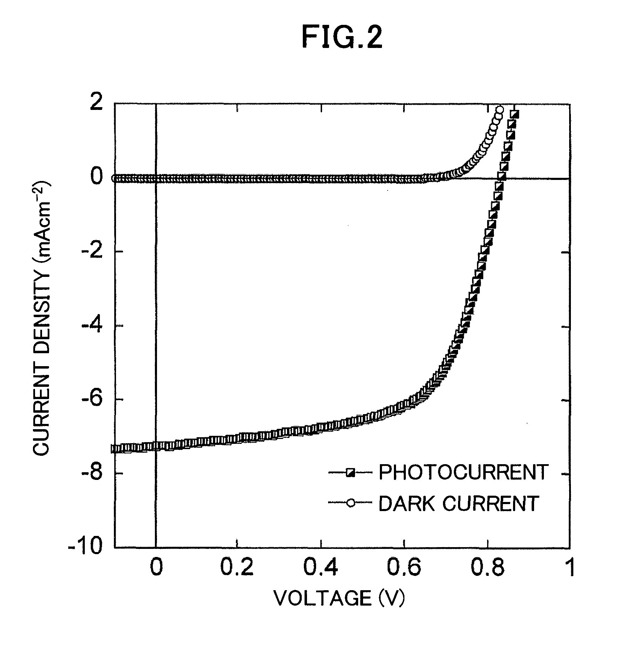

An organic thin film solar cell was produced in the same manner except that polymer compound P3/C₆₁ PCBM = 1/1 was set, and the characteristics thereof were evaluated. The current density-voltage characteristics indicated in FIG. 2 were obtained, Jsc = 7.50 mA/cm², Voc = 0.83 V, and FF = 0.60 were revealed, and η was 3.8%.

### (Evaluation of Solar Cell Element Using Polymer Compound P4)

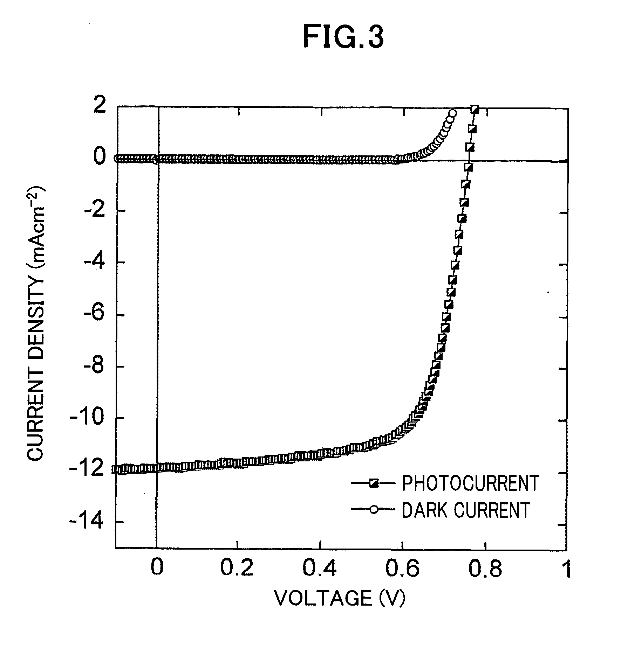

An organic thin film solar cell was produced in the same manner except that polymer compound P4/C₆₁ PCBM = 1/1.5 was set, and the characteristics thereof were evaluated. The current density-voltage characteristics indicated in FIG. 3 were obtained, Jsc = 12.0 mA/cm², Voc = 0.76 V, and FF = 0.69 were revealed, and η was 6.3%.

### (Evaluation of Solar Cell Element Using Polymer Compound P5)

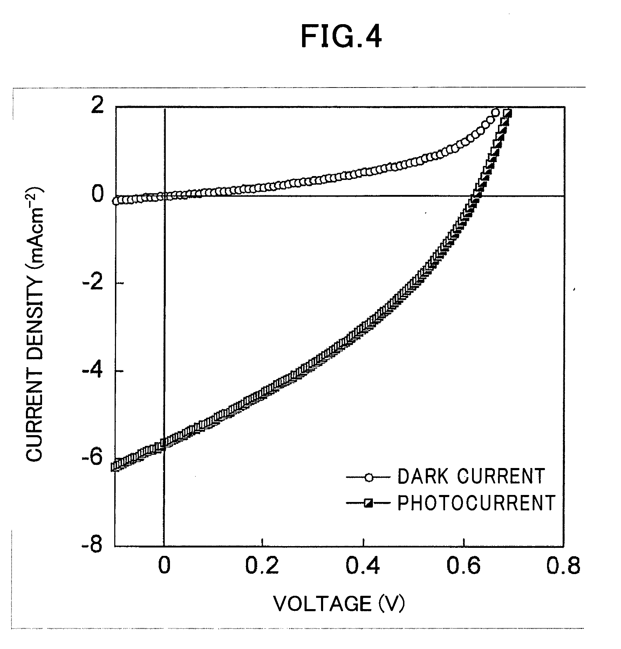

An organic thin film solar cell was produced in the same manner except that polymer compound P5/C₆₁ PCBM = 1/1 was set, and the characteristics thereof were evaluated. The current density-voltage characteristics as indicated in FIG. 4 were obtained, Jsc = 5.64 mA/cm², Voc = 0.63 V, and FF = 0.35 were revealed, and η was 1.2%.

In comparison with the polymer compound P5 comprising benzothiadiazole, each of the solar cell elements using the polymer compounds P1, P3, and P4 comprising naphthobisthiadiazole had a high photoelectric conversion efficiency value, exhibiting usefulness for a solar cell element. In particular, the polymer compound P4 comprising as a repeating unit a backbone in which a plurality of thiophene rings are bound to naphthobisthiadiazole had a photoelectric conversion efficiency of 6.3%, exceeding the world current highest level of 6% and exhibiting that the polymer compound P4 is very useful.

Subsequently, transistor elements were produced using the synthesized polymer compounds P2, P3, and P4, and the transistor characteristics thereof were evaluated.

### (Evaluation of Transistor Element Using Polymer Compound P2)

An n-type silicon substrate to be a gate electrode, which comprises a silicone oxide film of 200 nm and was doped at high concentration, was sufficiently cleaned, followed by silanizing the silicone oxide film surface of the substrate using hexamethyldisilazane (HMDS). The polymer compound P2 was dissolved in ortho-dichlorobenzene to produce 3 g/L of solution, which was filtrated through a membrane filter, followed by producing a thin polymer compound P2 film of about 50 nm on the above surface-treated substrate by a spin coating method. The thin film was heated under nitrogen atmosphere at 150°C for 30 minutes. Then, gold was vacuum-deposited to produce source and drain electrodes with a channel length of 50 µm and a channel width of 1.5 mm on the thin polymer film.

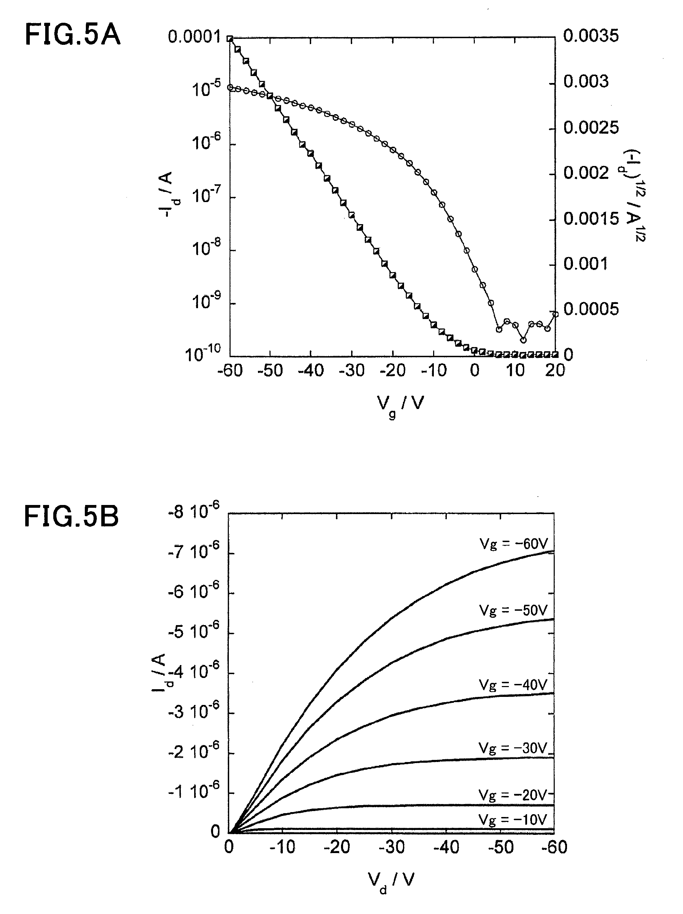

The characteristics of the transistor were measured with varying a gate voltage Vg of 20 to -60 V and a source-to-drain voltage Vsd of 0 to -60 V to the produced transistor element. The transfer and output characteristics are indicated in FIG. 5A and FIG. 5B, respectively. It was calculated from the characteristics that a Hall mobility was 0.05 cm²/Vs and a current on/off ratio was 4 x 10⁵.

### (Evaluation of Transistor Element Using Polymer Compound P3)

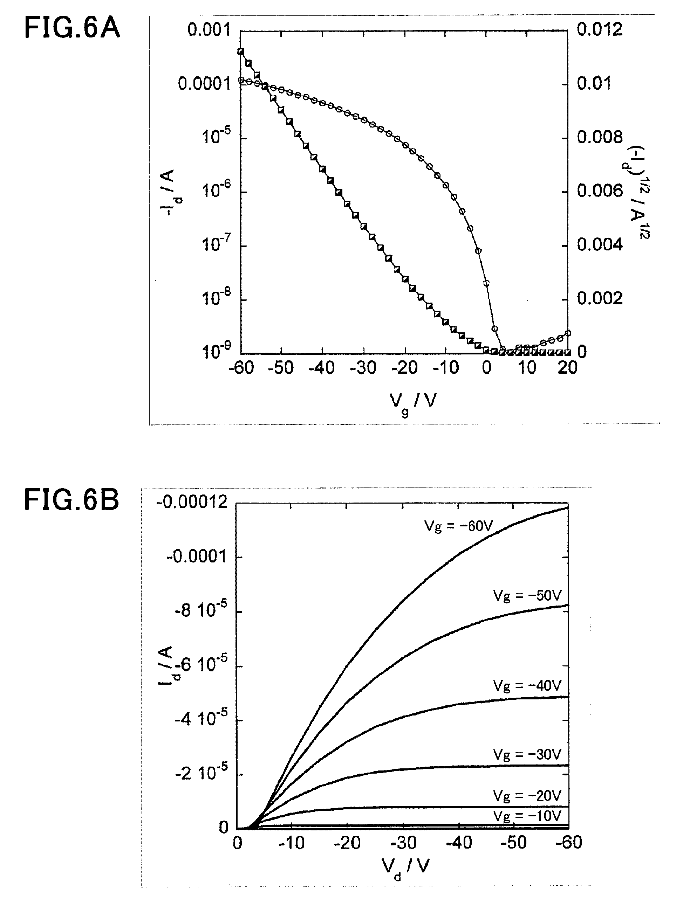

A transistor element was produced in the same manner described above except that the polymer compound P3 was used and perfluorodecyltrichlorosilane (FDTS) was used as a silanization agent, and was evaluated. The transfer and output characteristics are indicated in FIG. 6A and FIG. 6B, respectively. It was calculated from the characteristics that a Hall mobility was 0.54 cm²/Vs and a current on/off ratio was 1 x 10⁵.

### (Evaluation of Transistor Element Using Polymer Compound P4)

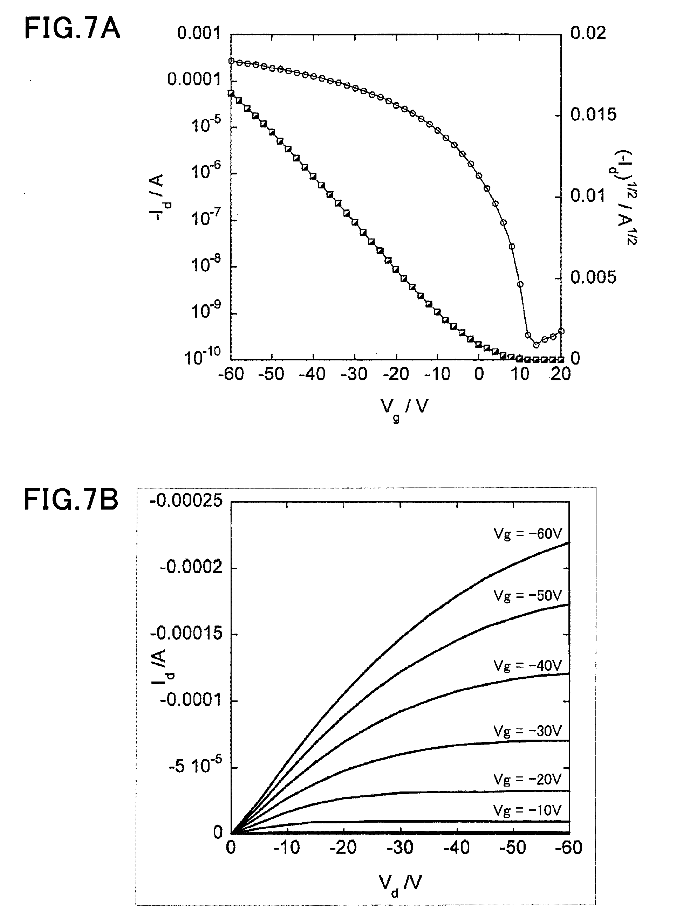

A transistor element was produced in the same manner described above except that the polymer compound P4 was used and perfluorodecyltrichlorosilane (FDTS) was used as a silanization agent, and was evaluated. The transfer and output characteristics are indicated in FIG. 7A and FIG. 7B, respectively. It was calculated from the characteristics that a Hall mobility was 0.45 cm²/Vs and a current on/off ratio was 1 x 10⁶.

Further, X-ray diffraction measurement of the organic semiconductor layers of the transistor elements using the polymer compounds P3 and P4 was conducted. The X-ray diffraction pattern of the organic semiconductor layer of the polymer compound P3 is indicated in FIG. 8. Further, the X-ray diffraction pattern of the organic semiconductor layer of the polymer compound P4 is indicated in FIG. 9.

It is confirmed that a second peak and a third peak appear at around 7 to 8° and around 11 to 12° in the out-of-plane X-ray diffraction patterns of the organic semiconductor layers of both polymer compounds P3 and P4. Such higher-order peaks are peaks observed in the case of a good crystal structure.

Furthermore, in the in-plane X-ray diffraction patterns of the organic semiconductor layers of both polymer compounds P3 and P4, a peak can be confirmed at 2θ = 25.3°, and a π-π stacking distance is 3.5 Å, and it is found that a spacing between polymer main chains is very short.

From the above, it can be considered that the good charge mobilities (Hall mobilities in the above case) as described above were exhibited since hopping of electrons easily occurred due to short spacings between polymer main chains and good crystal structures in the organic semiconductor layers of the polymer compounds P3 and P4.

### (Synthesis of Polymer Compounds P21 to P34)

Various polymer compounds (polymer compound P21 to polymer compound P34) were further synthesized as illustrated in the following reaction formulae.

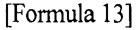

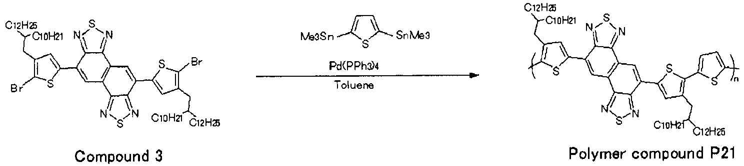

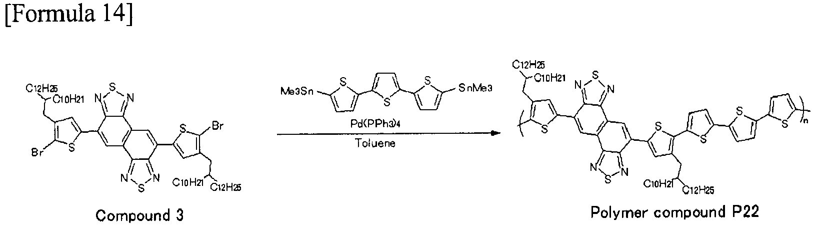

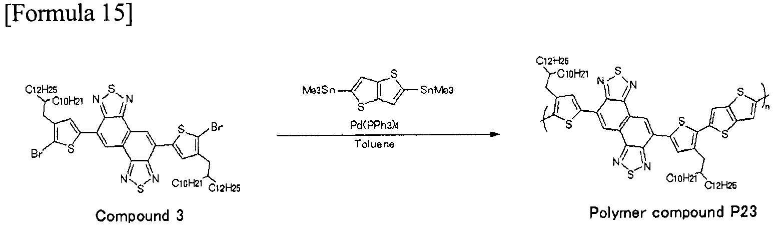

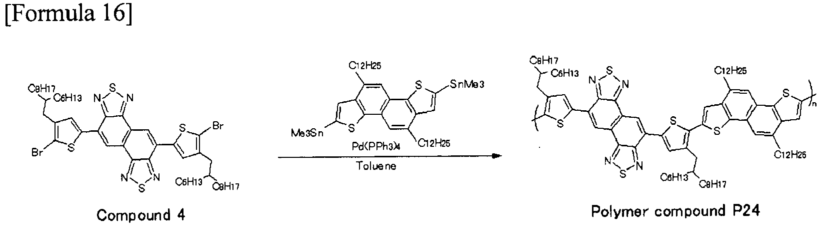

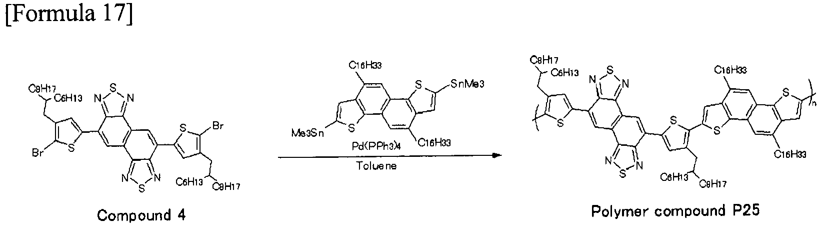

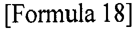

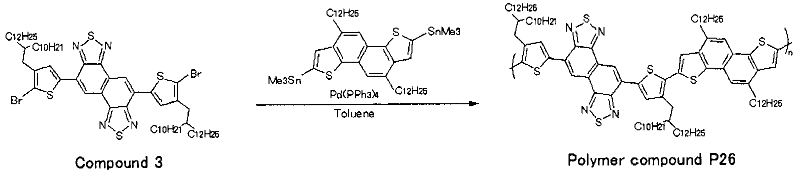

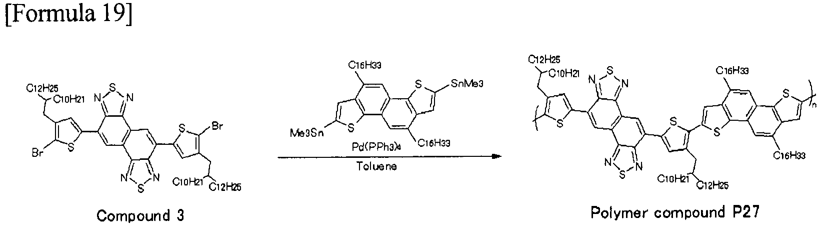

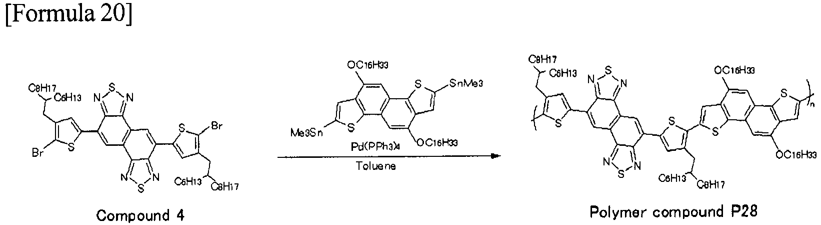

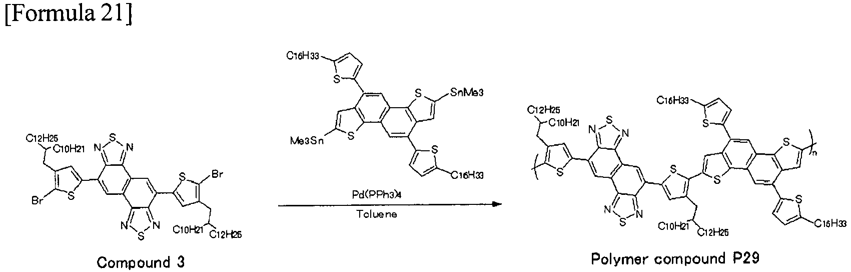

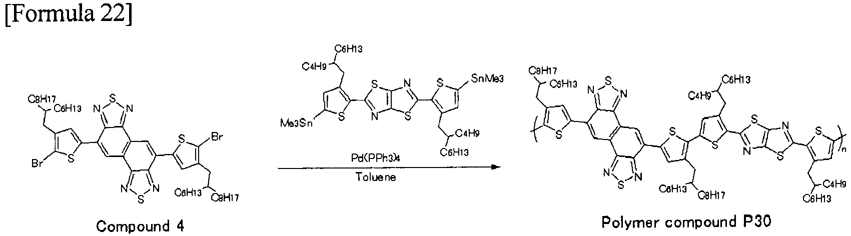

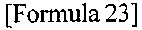

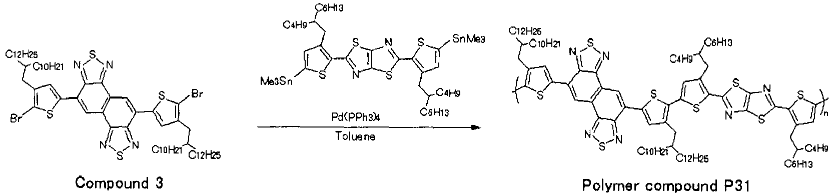

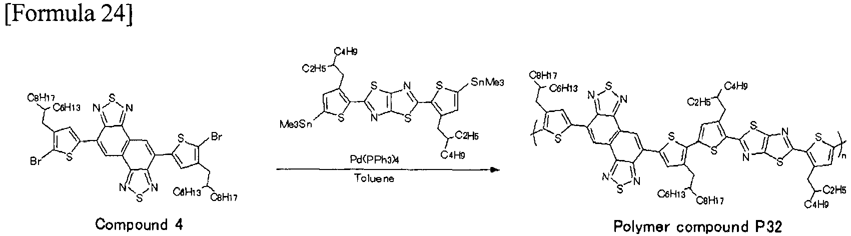

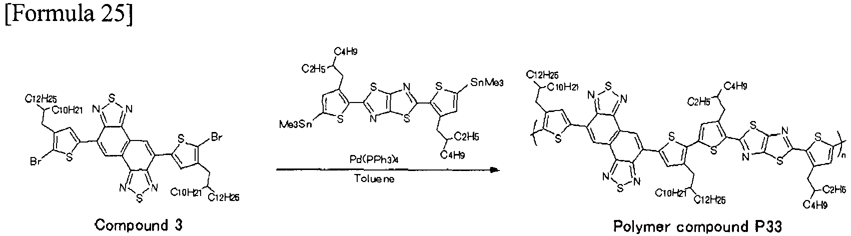

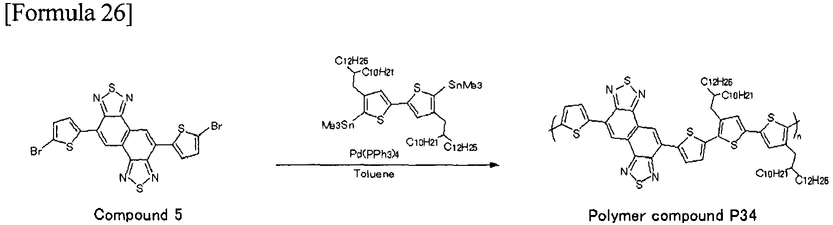

The synthesis of the polymer compounds P21 to P34 described above was performed according to the above-mentioned method for synthesizing the polymer compounds P3 and P4.

In addition, the compound 4 in the reaction formula described above was synthesized and used in the same manner as the synthesis of the compound 2 and the synthesis of the compound 3 mentioned above except that 4-(2-hexyldecyl)-2-trimethylstannylthiophene was used instead of 4-(2-decyltetradecyl)-2-trimethylstannylthiophene in the above-mentioned synthesis of the compound 2. Further, the compound 5 was synthesized and used in the same manner as the synthesis of the compound 2 and the synthesis of the compound 3 mentioned above except that 2-trimethylstannylthiophene was used instead of 4-(2-decyltetradecyl)-2-trimethylstannylthiophene in the above-mentioned synthesis of the compound 2.

### (Evaluation of Solar Cell Elements and Transistor Elements Using Polymer Compounds P21 to P34)

A solar cell element was produced according to the above-mentioned method for producing a solar cell element using each of the polymer compounds P21 to P34, and the characteristics thereof were evaluated. Further, a transistor element was produced according to the above-mentioned method for producing a transistor element using each of the polymer compounds P21 to P34, and the characteristics thereof were evaluated.

The number average molecular weight (Mn), weight average molecular weight (Mw), and molecular weight distribution (PDI) of each of the polymer compounds P21 to P34, the characteristics (short-circuit current density (Jsc), open voltage (Voc), fill factor (FF), and photoelectric conversion efficiency (η)) of each of the solar cell elements produced using the polymer compounds P21 to P34, and the characteristics (carrier mobility (µ) and on/off ratio (on/off)) of each of the transistors produced using the polymer compounds P21 to P34 are summarized in Table 1.

**[Table 1]**

| Polymer | *Mₙ* | *M_{w}* | PDI | µ (cm²/Vs) | on/off | *J_{SC}* (mA/cm²) | *V_{OC}* (V) | *FF* | *η* (%) |
|---|---|---|---|---|---|---|---|---|---|
| P21 | 25200 | 50700 | 2.01 | 0.03 | 10⁵ | 2.43 | 0.77 | 0.63 | 1.18 |
| P22 | 62700 | 190600 | 3.03 | 0.052 | 10⁴ | 10.51 | 0.73 | 0.65 | 5.06 |
| P23 | 76200 | 1535200 | 20.1 | 0.20 | 10⁵ | 11.07 | 0.74 | 0.53 | 4.33 |
| P24 | 36000 | 88900 | 2.47 | 0.21 | 10⁵ | 14.94 | 0.82 | 0.54 | 6.46 |
| P25 | 40000 | 83800 | 2.09 | 0.11 | 10⁶ | 9.32 | 0.83 | 0.57 | 4.42 |
| P26 | 46100 | 139200 | 3.02 | 0.051 | 10⁵ | 7.48 | 0.85 | 0.64 | 4.12 |
| P27 | 48400 | 142900 | 2.95 | 0.033 | 10⁷ | 5.67 | 0.85 | 0.59 | 2.77 |
| P28 | 31000 | 120800 | 3.89 | 0.013 | 10³ | 4.4 | 0.88 | 0.66 | 2.54 |
| P29 | 32700 | 60700 | 1.85 | 0.006 | 10⁴ | 1.82 | 0.88 | 0.48 | 0.77 |
| P30 | 29000 | 54000 | 1.80 | - | - | 2.77 | 0.86 | 0.63 | 1.5 |
| P31 | 25000 | 54000 | 2.20 | - | - | 2.57 | 0.88 | 0.64 | 1.47 |
| P32 | 27000 | 53000 | 2.00 | - | - | 3.82 | 0.80 | 0.52 | 1.61 |
| P33 | 38000 | 75000 | 2.00 | - | - | 8.11 | 0.84 | 0.58 | 3.91 |
| P34 | 27000 | 51000 | 1.87 | 0.56 | 10⁴ | 8.46 | 0.74 | 0.63 | 3.91 |

In the present invention, various embodiments and modifications are possible without departing from the scope of the present invention. Further, the above-mentioned embodiments are intended to explain the present invention and not to limit the scope of the present invention.

The present application is based on Japanese Patent Application No. 2011-162625 filed on July 25, 2011. All the specification, claims, and drawings of Japanese Patent Application No. 2011-162625 are incorporated herein by reference.

### Industrial Applicability

The organic semiconductor material can be used as an organic transistor or an organic thin film solar cell because of exhibiting good electrolysis mobility and photoelectric conversion efficiency.

## Claims

1. An organic semiconductor material comprising a backbone represented by formula 1: 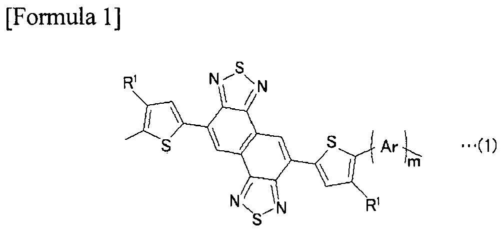 (in formula 1, R¹ is hydrogen, an alkyl group, an alkylcarbonyl group, an alkoxy group, and an alkoxycarbonyl group, m is an integer of 1 or more, Ar is a monocyclic or condensed polycyclic heteroaromatic ring optionally comprising a substituent, and when a plurality of heteroaromatic rings are linked, the same or different heteroaromatic rings are optionally linked).

2. The organic semiconductor material according to Claim 1,
that is a polymer compound comprising the backbone as a repeating unit.

3. The organic semiconductor material according to Claim 1 or 2, wherein
the monocyclic heteroaromatic ring is a thiophene ring or a selenophene ring.

4. The organic semiconductor material according to Claim 1 or 2, wherein
the condensed polycyclic heteroaromatic ring is represented by any of formula 11 to formula 16: 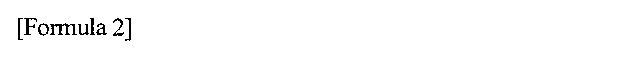 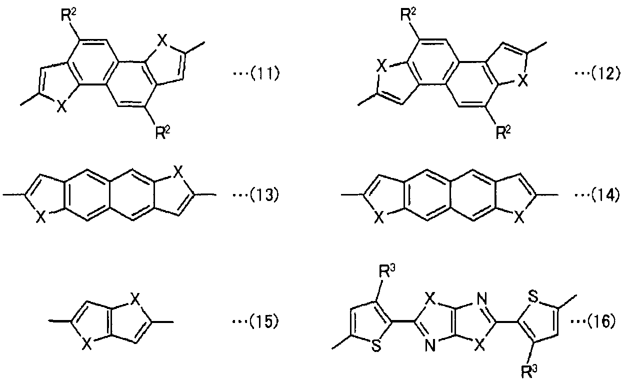 (in formula 11 to formula 16, X represents an oxygen, sulfur, or selenium atom; in formula 11 and formula 12, R² represents hydrogen, an alkyl group, an alkylcarbonyl group, an alkoxy group, an alkoxycarbonyl group, or an aromatic ring optionally comprising a substituent; and in formula 16, R³ represents an alkyl group, an alkylcarbonyl group, an alkoxy group, or an alkoxycarbonyl group).

5. An organic semiconductor material represented by any of formula 21 to formula 24: 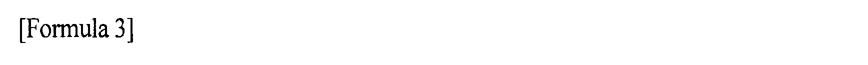 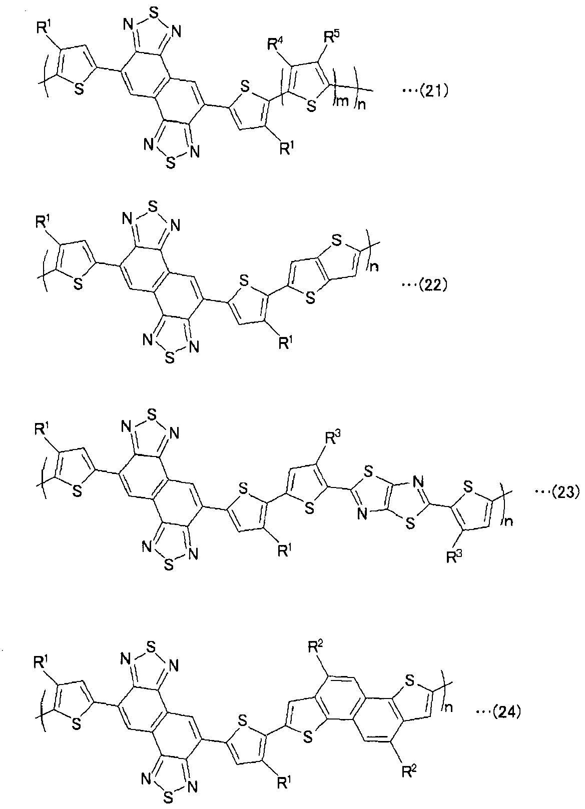 (in formula 21 to formula 24, R¹ represents hydrogen, an alkyl group, an alkylcarbonyl group, an alkoxy group, or an alkoxycarbonyl group, and n represents a positive real number; in formula 21, R⁴ and R⁵ represent hydrogen, an alkyl group, an alkylcarbonyl group, an alkoxy group, or an alkoxycarbonyl group, and m represents an integer of 1 or more; in formula 23, R³ represents an alkyl group, an alkylcarbonyl group, an alkoxy group, or an alkoxycarbonyl group; and in formula 24, R² represents hydrogen, an alkyl group, an alkylcarbonyl group, an alkoxy group, an alkoxycarbonyl group, or an aromatic ring optionally comprising a substituent).
